# EUROPÄISCHE PATENTANMELDUNG

(11) **EP 2 983 213 A1**
(43) Veröffentlichungstag der Anmeldung: **10.02.2016**
(21) Anmeldenummer: 14002779.8
(22) Anmeldetag: 08.08.2014
(51) Int. Cl.: H01L 31/0687

(54) **Skalierbare Spannungsquelle**

(71) Anmelder: AZUR SPACE Solar Power GmbH, 74072 Heilbronn (DE)
(72) Erfinder: Fuhrmann, Daniel, 74074 Heilbronn (DE); Khorenko, Victor, 74196 Neuenstadt a.K. (DE); Guter, Wolfgang, 70190 Stuttgart (DE)
(74) Vertreter: Koch Müller Patentanwaltsgesellschaft mbH

(57) **Zusammenfassung**

Skalierbare Spannungsquelle mit einer Anzahl N zueinander in Serie geschalteten Teilspannungsquellen, wobei jede der Teilspannungsquellen eine Halbleiterdiode mit einen p-n Übergang aufweist und zwischen jeweils zwei aufeinanderfolgenden Teilspannungsquellen eine Tunneldiode ausgebildet ist, wobei die Teilspannungsquellen und die Tunneldioden zusammen monolithisch integriert sind und gemeinsam einen ersten Stapel mit einer Oberseite und einer Unterseite ausbilden, und die Anzahl N der Teilspannungsquellen größer gleich drei ist und bei 300 K der erste Stapel eine Quellenspannung von größer als 4 Volt aufweist, sofern der erste Stapel mit einem Photonenstrom mit einer bestimmten Wellenlänge bestrahlt ist.

## Beschreibung

Die Erfindung betrifft eine skalierbare Spannungsquelle.

Skalierbare Spannungsquellen sind hinlänglich beispielsweise aus einer Serienschaltung von Batterien oder aus einer Serienschaltung von Netzteilen oder Kondensatoren bekannt.

Vor diesem Hintergrund besteht die Aufgabe der Erfindung darin, eine Vorrichtung anzugeben, die den Stand der Technik weiterbildet.

Die Aufgabe wird durch eine skalierbare Spannungsquelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine skalierbare Spannungsquelle mit einer Anzahl N zueinander in Serie geschalteten Teilspannungsquellen bereitgestellt, wobei jede der Teilspannungsquellen eine Halbleiterdiode mit einen p-n Übergang aufweist und wobei die Quellenspannung der Teilspannungsquelle zueinander weniger als 20% abweichen, und zwischen jeweils zwei aufeinanderfolgenden Teilspannungsquellen eine Tunneldiode ausgebildet ist, wobei die Teilspannungsquellen und die Tunneldioden zusammen monolithisch integriert sind und gemeinsam einen ersten Stapel mit einer Oberseite und einer Unterseite ausbilden, und die Anzahl N der Teilspannungsquellen größer gleich drei ist und bei 300 K der erste Stapel eine Quellenspannung von insgesamt größer als 4 Volt aufweist, sofern der erste Stapel mit einem Photonenstrom mit einer bestimmten Wellenlänge bestrahlt ist. Es versteht sich, dass die Anzahl Teilspannungsquellen vorzugsweise unterhalb zehn liegt.

Ein Vorteil der erfindungsgemäßen Vorrichtung ist es, dass durch die Hintereinanderschaltung von einer Vielzahl von Teilspannungsquellen eine Spannungsquelle mit Spannungswerten auch oberhalb von 5 oder mehr Volt herstellen lässt in einem monolithisch integrierten Aufbau. Hierdurch wird die eine kostengünstige zuverlässige Spannungsquelle herstellbar.

In einer Weiterbildung weicht die Quellenspannung der einzelnen Teilspannungsquellen untereinander weniger als 10% ab. Hierdurch wird die Einsetzbarkeit als skalierbare Spannungsquelle insbesondere als Referenzspannungsquelle wesentlich verbessert.

In einer anderen Weiterbildung weisen die Halbleiterdioden jeweils das gleiche Halbleitermaterial auf. Auch ist es vorteilhaft, den ersten Stapel auf einem Substrat anzuordnen. Vorzugsweise umfasst das Substrat ein Halbleitermaterial insbesondere Silizium und / oder Germanium und / oder ein III-V Material wie beispielsweise GaAs. Es ist bevorzugt, auf der Unterseite des ersten Stapels ein zweiter Spannungsanschluss auszubilden und insbesondere, dass der zweite Spannungsanschluss durch das Substrat ausgebildet ist.

In einer anderen Ausführungsform bestehen die Halbleiterdioden aus dem gleichen Material wie das Substrat. Ein Vorteil ist, dass sich dann insbesondere die Ausdehnungskoeffizienten der beiden Teile gleichen. Es ist vorteilhaft, wenn die Halbleiterdioden grundsätzlich aus einem III-V Material bestehen.

In einer bevorzugten Ausführungsform ist auf der Oberseite des ersten Stapels ein erster Spannungsanschluss als ein umlaufender Metallkontakt in der Nähe des Randes ausgebildet.

Des Weiteren ist es bevorzugt, wenn der erste Stapel eine Grundfläche kleiner als 2 mm² oder kleiner als 1 mm² aufweist. Untersuchungen haben gezeigt, dass es vorteilhaft ist, die Grundfläche viereckig auszubilden. Vorzugsweise ist die Grundfläche des Stapels quadratisch ausgebildet.

Weitere Untersuchungen haben gezeigt, dass um besonderes hohe Spannungen zu erzielen es vorteilhaft ist, einen zweiten Stapel auszubilden und die beiden Stapel miteinander in Serie zu verschalten, so dass sich die Quellenspannung des ersten Stapels und die Quellenspannung des zweiten Stapels addieren. Vorzugsweise sind der erste Stapel und der zweite Stapel nebeneinander auf einem gemeinsamen Träger angeordnet.

In einer Weiterbildung weicht die Quellenspannung des ersten Stapels von der Quellenspannung des zweiten Stapels um weniger als 15 % ab.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine erste erfindungsgemäße Ausführungsform einer skalierbaren Spannungsquelle mit einem Stapel,
- Figur 2: eine zweite Ausführungsform einer skalierbaren Spannungsquelle mit mehreren Stapeln.

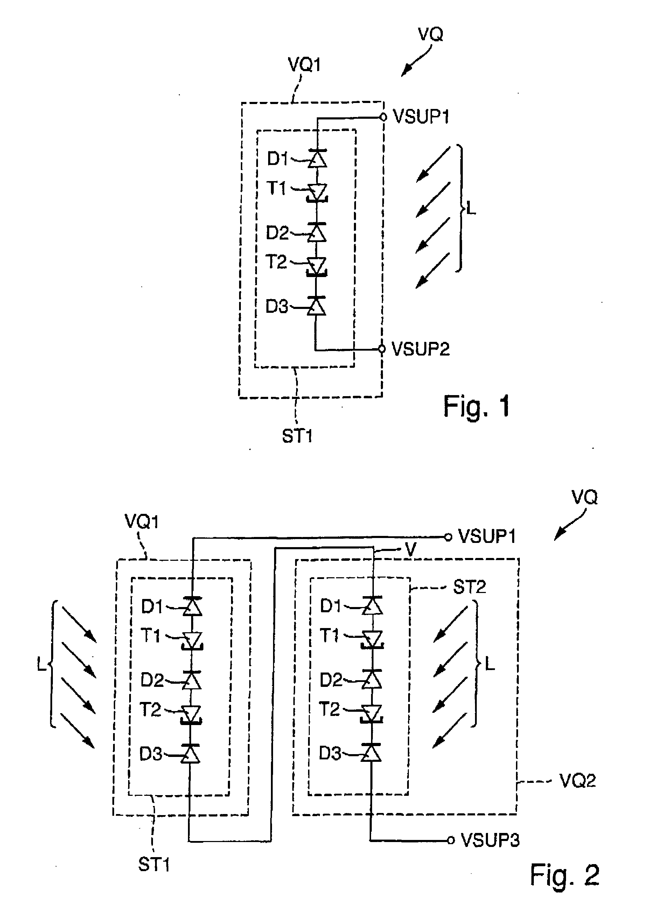

Die Abbildung der Figur 1 zeigt eine schematische Ansicht einer ersten Ausführungsform, aufweisend eine skalierbare Spannungsquelle VQ1 mit einem ersten Stapel ST1 mit einer Oberseite und einer Unterseite mir einer Anzahl N gleich drei Dioden. Der erste Stapel ST1 weist eine Serienschaltung aus einer ersten Diode D1 und einer ersten Tunneldiode T1 und einer zweiten Diode D2 und einer zweiten Tunneldiode T2 und einer dritten Diode D3 auf.

An der Oberseite des Stapel VQ1 ist ein erster Spannungsanschluss VSUP1 und der Unterseite des Stapel VQ2 ein zweiter Spannungsanschluss VSUP2 ausgebildet. Die Quellenspannung setzt sich vorliegend im Wesentlichen aus den Teilspannungen der einzelnen Dioden D1 bis D3 zusammen. Hierzu ist der erste Stapel ST1 einem Photonenstrom L ausgesetzt.

Der erste Stapel ST1 der Dioden D1 bis D3 und den Tunneldioden T1 und T2 ist als monolithisch ausgebildeter Block, vorzugsweise aus dem gleichen Halbmaterial, ausgeführt.

In der Abbildung der Figur 2 ist eine weitere Ausführungsform einer vorteilhaften Aneinanderreihung von dem ersten Stapel ST1 und einem zweiten Stapel ST2 ausgebildet. Im Folgenden werden nur die Unterschiede zu der Abbildung der Figur 1 erläutert. Der zweite Stapel ST2 weist wie der erste Stapel ST1 eine Serienschaltung aus drei Dioden mit dazwischen ausgebildeten Tunneldioden auf. Beide Stapel ST1 und ST2 sind miteinander in Serie verschaltet, sodass sich die Quellenspannung VQ1 des ersten Stapels ST1 und die Quellenspannung VQ2 des zweiten Stapel ST2 sich addieren, sofern die beiden Stapel ST1 und ST2 dem Photonenstrom L ausgesetzt sind. Die addierte Quellenspannung liegt nun zwischen dem ersten Spannungsanschluss VSUP1 und einem dritten Spannungsanschluss VSUP3 an.

In einer nicht dargestellten Ausführungsform weisen die beiden Stapel ST1 und ST2 zueinander eine unterschiedliche Anzahl von jeweils in einer Serienschaltung verbundenen Dioden auf. In einer anderen nicht dargestellten Ausführungsform sind je Stapel mehr als drei Dioden, vorzugsweise mit einer Anzahl N in einem Bereich zwischen vier und acht Dioden angeordnet. In einer Weiteren nicht dargestellten Ausführungsform sind die beiden Stapel zueinander parallel geschaltet.

## Patentansprüche

1. Skalierbare Spannungsquelle (VQ) aufweisend
- eine Anzahl N zueinander in Serie geschalteten Teilspannungsquellen, wobei jede der Teilspannungsquellen eine Halbleiterdiode (D1, D2, D3) mit einen p-n Übergang aufweist und die Teilquellenspannungen der einzelnen Teilspannungsquellen zueinander einer Abweichung kleiner als 20% aufweisen, und
- zwischen jeweils zwei aufeinanderfolgenden Teilspannungsquellen eine Tunneldiode (T1, T2) ausgebildet ist, wobei
- die Teilspannungsquellen und die Tunneldioden (T1, T2) zusammen monolithisch integriert sind, und gemeinsam einen ersten Stapel (ST1) mit einer Oberseite und einer Unterseite ausbilden, und die Anzahl N der Teilspannungsquellen größer gleich drei ist, und
- bei 300 K der erste Stapel (ST1) eine Quellenspannung (VQ1) von größer als 4 Volt aufweist, sofern der erste Stapel (ST1) mit einem Photonenstrom (L) mit einer bestimmten Wellenlänge bestrahlt ist.

2. Skalierbare Spannungsquelle (VQ) nach Anspruch 1, **dadurch gekennzeichnet, dass** die Quellenspannung (VQ1) der einzelnen Teilspann ungsquellen zueinander einer Abweichung kleiner als 10% aufweisen.

3. Skalierbare Spannungsquelle (VQ) nach Anspruch 1 oder Anspruch 2, **dadurch gekennzeichnet, dass** die Halbleiterdioden (D1, D2, D3) jeweils das gleiche Halbleitermaterial aufweisen.

4. Skalierbare Spannungsquelle (VQ) nach einem der vorangegangenen Ansprüche, **dadurch gekennzeichnet, dass** der erste Stapel (ST1) auf einem Substrat angeordnet ist und das Substrat ein Halbleitermaterial umfasst.

5. Skalierbare Spannungsquelle (VQ) nach einem der vorangegangenen Ansprüche, **dadurch gekennzeichnet, dass** der erste Stapel (ST1) eine Grundfläche kleiner als 2 mm² oder kleiner als 1 mm² aufweist.

6. Skalierbare Spannungsquelle (VQ) nach Anspruch 5, **dadurch gekennzeichnet, dass** die Grundfläche viereckig ausgebildet ist.

7. Skalierbare Spannungsquelle (VQ) nach einem der vorangegangenen Ansprüche, **dadurch gekennzeichnet, dass** auf der Oberseite des ersten Stapels ein erster Spannungsanschluss (VSUP) als ein umlaufender Metallkontakt in der Nähe des Randes ausgebildet ist.

8. Skalierbare Spannungsquelle (VQ) nach einem der vorangegangenen Ansprüche, **dadurch gekennzeichnet, dass** auf der Unterseite des ersten Stapels ein zweiter Spannungsanschluss (VSUP2) ausgebildet ist.

9. Skalierbare Spannungsquelle (VQ) nach Anspruch 4 und Anspruch 8, **dadurch gekennzeichnet, dass** der zweite Spannungsanschluss (VSUP2) durch das Substrat ausgebildet ist.

10. Skalierbare Spannungsquelle (VQ) nach einem der vorangegangenen Ansprüche, **dadurch gekennzeichnet, dass** ein zweiter Stapel (ST2) ausgebildet ist und der erste Stapel (ST1) und der zweite Stapel (ST2) nebeneinander auf einem gemeinsamen Träger angeordnet sind und die beiden Stapel (ST1, ST2) miteinander in Serie verschaltet sind, so dass sich die Quellenspannung (VQ1) des ersten Stapels (ST1) und die Quellenspannung (VQ2) des zweiten Stapels (ST2) addieren.

11. Skalierbare Spannungsquelle (VQ) nach Anspruch 10, **dadurch gekennzeichnet, dass** die Quellenspannung (VQ1) des ersten Stapels (ST1) von der Quellenspannung (VQ2) des zweiten Stapels (ST2) um weniger als 15 % abweicht.

12. Skalierbare Spannungsquelle (VQ) nach einem der vorangegangenen Ansprüche, **dadurch gekennzeichnet, dass** das Halbleitermaterial und / oder das Substrat aus einem III-V Material bestehen.

13. Skalierbare Spannungsquelle (VQ) nach Anspruch 4, **dadurch gekennzeichnet, dass** das Halbleitermaterial Germanium umfasst.
